# EUROPEAN PATENT APPLICATION

(11) **EP 2 355 343 A2**
(43) Date of publication of application: **10.08.2011**
(21) Application number: 11153441.8
(22) Date of filing: 04.02.2011
(51) Int. Cl.: H03H 9/10

(54) **Method of manufacturing package and method of manufacturing piezoelectric vibrator**

(30) Priority: 05.02.2010 JP 2010024655
(71) Applicant: Seiko Instruments Inc., Chiba-shi, Chiba (JP)
(72) Inventor: Tange, Yoshihisa, Chiba-shi, Chiba (JP); Yoshida, Yoshifumi, Chiba-shi, Chiba (JP)
(74) Representative: Cloughley, Peter Andrew

(57) **Abstract**

Provided is a method of manufacturing a package capable of providing a plurality of through-electrodes in a base substrate made of a glass material with high position precision. An electrode member having a plurality of pins erected on a base is prepared, the plurality of pins is inserted into a plurality of through-holes of a glass substrate provided with the plurality of through-holes, the resultant is heated to a temperature higher than the softening point of the glass substrate to weld the corresponding through-holes and the pins to each other, the glass substrate is ground after cooling to remove the base, and the pins are exposed from both surfaces of the glass substrate, thereby forming through-electrodes which are electrically separated from each other.

## Description

The present invention relates to a manufacturing method of forming a plurality of through-electrodes adjacent to a substrate and a method of manufacturing a piezoelectric vibrator using the same.

In recent years, piezoelectric vibrators using crystals or the like have been used as time sources or timing sources for portable phones or portable information terminal devices. Various types of piezoelectric vibrators are known, and as an example, a surface-mounted piezoelectric vibrator is known. As this type of piezoelectric vibrator, there is one known having a three-layer structure in which a piezoelectric substrate provided with a piezoelectric vibrating reed is interposed between a base substrate and a lid substrate in the vertical direction, followed by bonding. The piezoelectric vibrating reed is accommodated in a cavity provided between the base substrate and the lid substrate.

In addition, recently, a piezoelectric vibrator with a two-layer structure type has been developed. This type has a two-layer structure type package in which a base substrate and a lid substrate are directly bonded to each other, and a piezoelectric vibrating reed is accommodated in a cavity between the base substrate and the lid substrate. A piezoelectric element with the two-layer structure type is excellent because it can achieve a reduction in thickness compared to the three-layer structure type.

In JP-A-2002-124845 and JP-A-2002-121037, a crystal oscillator package in a two-layer structure type is disclosed. A glass material is used as a package material of a base substrate and a lid substrate. Since the glass material is used, molding is easily performed as compared with a case where a ceramic is used, and manufacturing costs can be reduced. In addition, the glass material has a low thermal conductivity and excellent thermal insulation, so that a piezoelectric vibrator therein can be protected from temperature changes.

The base substrate made of the glass material is provided with two through-electrodes and can supply drive power to the crystal oscillator from outside. A solidified silver paste or a metal member may be used for the through-electrode. The through-electrodes and a cavity are formed by performing die-molding on the glass material. Specifically, a glass substrate for the base substrate is interposed between a lower die which is a stationary die and an upper die which is a movable die. The upper die is provided with a pin for through-hole formation and a convex portion for cavity formation, and the lower die is provided with a concave portion for pin reception and a convex portion for the cavity formation. The glass plate for the base substrate is interposed between the upper and lower dies, and the glass plate is heated to its softening point or higher and is subjected to molding. Accordingly, the cavity for accommodating the crystal oscillator and the through-hole for electrode formation are simultaneously formed. Next, the though-hole is filled with the silver paste, and the silver paste is solidified to be used as the through-electrode. Otherwise, while the glass plate is heated and softened, the metal members as headed pins are individually inserted into the through-holes and cooled to be used as the through-electrodes. In addition, the crystal oscillator is fixed to a head portion of the headed pin with an adhesive.

In JP-A-2003-209198, a crystal oscillator package having the two-layer structure type as described above is disclosed. Even in this case, a method of using a glass material as a base substrate and forming through-electrodes using a metal material on the base substrate is disclosed. Specifically, through-holes are formed by performing die-molding on a base member made of the glass material. Next, a glass frit made of a low-melting-point glass is attached to the through-hole, and a headed metal pin is individually inserted into the through-hole. In addition, the base substrate is placed on a lower press die and is heated to a softening point or higher of the base substrate along with an upper press die to melt the glass frit, and a gap between the metal pin and the through-hole is sealed, thereby forming the through-electrode.

A reduction in size is required for the piezoelectric vibrators used in the portable phones or the portable information terminal devices. For example, as a size of the package of the piezoelectric vibrator, a size of several millimeters or less is required. In order to implement this, the shape of the piezoelectric vibrating reed has to be reduced, and the diameter of the through-electrode or the interval between the through-electrodes has to be reduced. For example, in the case where the through-electrodes are formed of the silver paste on the base substrate made of the glass material, two through-holes may be formed with high precision. However, with regard to the through-electrode formed of the silver paste, an organic material such as resin is removed from the silver paste during a baking process and thus the volume of the through-electrode is reduced, so that concave portions are generated on the surface of the through-electrode or a hole is generated on the through-electrode. Therefore, there are problems in that airtightness of the cavity is degraded, or conductivity between the piezoelectric vibrating reed and an outer electrode is degraded.

In addition, in the case where the metal pins are individually inserted into a plurality of the through-holes provided in the base substrate made of the glass material and the glass material is heated to a temperature equal to or higher than its softening point to weld the glass material and the metal pins to each other, the glass material is softened and made to flow, and thus although the through-holes are formed with high precision, position precision of the through-electrode is degraded. Particularly, when the glass material is interposed between the lower die and the upper die and then the metal pins and the glass material are heated to a temperature equal to or higher than the softening point of the glass material and pressed to be welded to each other, the two metal electrodes are moved, so that there is a problem in that desired position precision cannot be obtained.

In addition, even with regard to packages other than a crystal oscillator, if through-electrodes made of a metal material are formed on a base substrate made of a glass material for a package in which the diameters of the through-electrodes are small and high position precision and high airtightness are required, the same problem occurs.

In order to solve the above problems, an object of the invention is to provide a method of manufacturing a package capable of forming a through-electrode made of a metal material on a base substrate made of a glass material with high position precision.

A method of manufacturing a package according to the invention is a method of manufacturing a package for bonding a lid substrate onto a base substrate made of a glass material and accommodating an electronic component in a cavity configured therein, the method including: a through-hole forming step of providing a plurality of through-holes in a glass substrate; an electrode pin inserting step of preparing an electrode member having a plurality of pins erected on a base, and inserting the plurality of pins into the plurality of through-holes respectively; a welding step of heating the glass substrate to a temperature higher than the softening point of the glass substrate and welding the glass substrate and the electrode member to each other; and a grinding step of grinding both surfaces of the glass substrate along with the electrode member, exposing the plurality of pins from both surfaces of the glass substrate, and forming a base substrate having a plurality of through-electrodes in which through-electrodes are electrically separated from each other.

In addition, in the welding step, the glass substrate into which the plurality of pins is inserted may be nipped between a receiving die and a pressurizing die and pressurized.

In addition, the through-hole forming step may include: a concave portion forming step of providing a plurality of convex portions in any one of the receiving die and the pressurizing die made of a carbon material, nipping the glass substrate between the receiving die and the pressurizing die and heating, and forming a plurality of concave portions on one surface of the glass substrate; and a penetrating step of grinding the other surface which is on the reverse side to the one surface of the glass substrate, and penetrating the plurality of concave portions from the one surface to the other surface.

In addition, a cooling step of cooling the glass substrate and the electrode member after the welding step may be further included, and in the cooling step, compared to a cooling rate applied during cooling to a temperature 50°C higher than the strain point of the glass substrate, a cooling rate applied during cooling from the temperature 50°C higher than the strain point thereof to a temperature 50°C lower than the strain point thereof is set to be smaller.

In addition, an axis-to-axis distance between center axes of the plurality of pins is preferably in the range of 0.5 mm to 1.5 mm.

A method of manufacturing a piezoelectric vibrator according to the invention includes: a mounting step of mounting a piezoelectric vibrator on the base substrate manufactured as per any one of the package manufacturing methods described above; and a bonding step of bonding the lid substrate to the base substrate by anodic bonding.

In the method of manufacturing a package according to the invention, glass is used for the base substrate and thus the base substrate can be easily processed, and the glass substrate and the electrode member are welded to each other and thus airtightness of the package is further enhanced. Moreover, since the positions of the plurality of electrode pins are fixed in the welding step of welding the glass substrate to the electrode member, the plurality of electrode pins do not move relative to each other during welding. As a result, the plurality of through-electrodes can be positioned with high precision.

Embodiments of the present invention will now be described by way of further example only and with reference to the accompanying drawings, in which:
Fig. 1 is a diagram of an outer appearance of a package manufactured by a method of manufacturing a package according to an embodiment of the invention.
Fig. 2 is a top view schematically illustrating a base substrate of the package manufactured by the method of manufacturing a package according to the embodiment of the invention.
Fig. 3 is a cross-sectional view schematically illustrating a piezoelectric vibrator manufactured by a method of manufacturing a piezoelectric vibrator according to the embodiment of the invention.
Fig. 4 is a flowchart illustrating the method of manufacturing a package according to the embodiment of the invention.
Fig. 5 is a perspective view of a glass substrate for explaining the method of manufacturing a package according to the embodiment of the invention.
Figs. 6A and 6B are perspective views of electrode members for explaining the method of manufacturing a package according to the embodiment of the invention.
Fig. 7 is a cross-sectional view schematically illustrating the glass substrate for explaining the method of manufacturing a package according to the embodiment of the invention.
Fig. 8 is a cross-sectional view schematically illustrating the glass substrate for explaining the method of manufacturing a package according to the embodiment of the invention.
Fig. 9 is a cross-sectional view schematically illustrating the base substrate for explaining the method of manufacturing a package according to the embodiment of the invention.
Fig. 10 is a flowchart illustrating the method of manufacturing a package according to the embodiment of the invention.
Fig. 11 is an explanatory view of a concave portion forming step of the method of manufacturing a package according to the embodiment of the invention.
Fig. 12 is an explanatory view of the concave portion forming step of the method of manufacturing a package according to the embodiment of the invention.
Fig. 13 is an explanatory view of the concave portion forming step of the method of manufacturing a package according to the embodiment of the invention.
Fig. 14 is an explanatory view of a penetrating step of the method of manufacturing a package according to the embodiment of the invention.
Fig. 15 is an explanatory view of an insertion step of the method of manufacturing a package according to the embodiment of the invention.
Fig. 16 is an explanatory view of the insertion step of the method of manufacturing a package according to the embodiment of the invention.
Fig. 17 is a cross-sectional view schematically illustrating the glass substrate for explaining the method of manufacturing a package according to the embodiment of the invention.
Fig. 18 is a cross-sectional view schematically illustrating the base substrate for explaining the method of manufacturing a package according to the embodiment of the invention.
Fig. 19 is a top view schematically illustrating the glass substrate for explaining the method of manufacturing a package according to the embodiment of the invention.
Fig. 20 is a flowchart illustrating the method of manufacturing a piezoelectric vibrator according to the embodiment of the invention.
Fig. 21 is a top view schematically illustrating an oscillator using the piezoelectric vibrator manufactured by the method of manufacturing a piezoelectric vibrator according to the embodiment of the invention.

### Example of Package

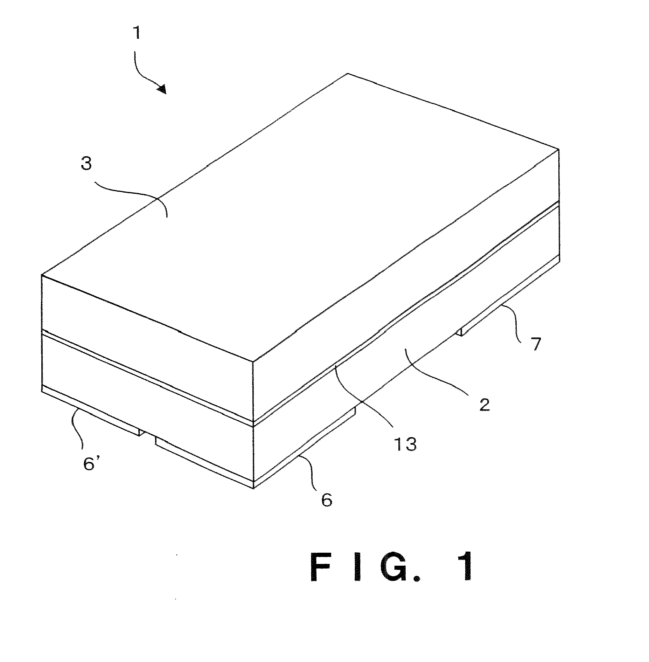

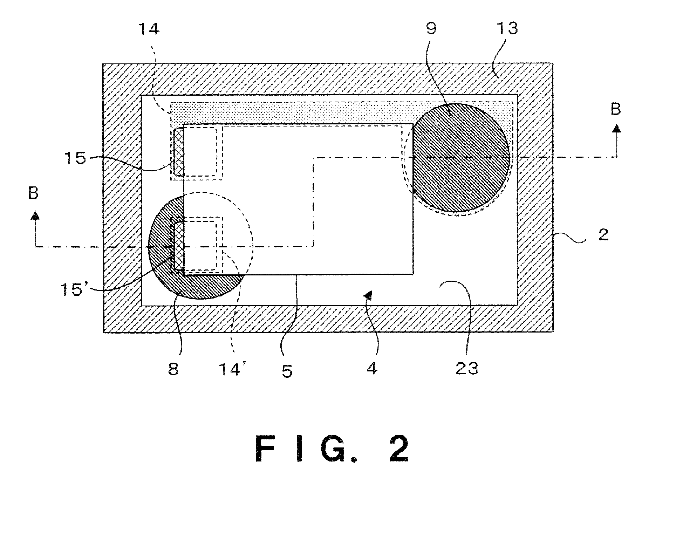

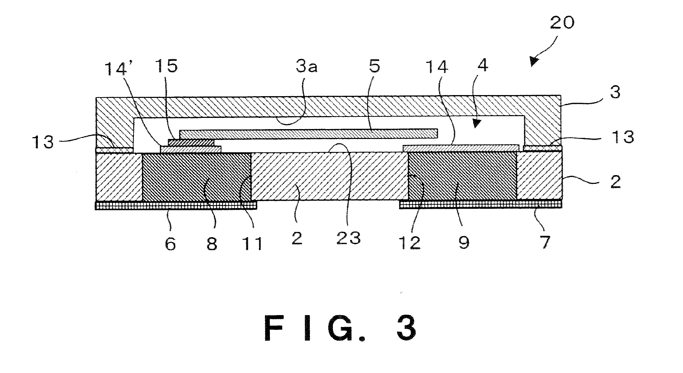

Before describing a method of manufacturing a package according to the invention, for easy understanding, an example of a package manufactured by the method of manufacturing a package according to the invention is described. Fig. 1 is a diagram of an outer appearance of a package 1 manufactured by the method of manufacturing a package according to a first embodiment of the invention. Fig. 2 is a top view schematically illustrating a base substrate 2 having a piezoelectric vibrating reed 5 mounted on an inner surface 23 of the base substrate 2. Fig. 3 is a cross-sectional view schematically illustrating a piezoelectric vibrator 20 formed by bonding a lid substrate 3 to the base substrate 2, the piezoelectric vibrator 20 being taken along the line B-B of Fig. 2.

As illustrated in Fig. 1, the package 1 has the base substrate 2 having a rectangular shape, and the lid substrate 3 having a rectangular shape bonded thereon. The base substrate 2 has outer electrodes 6 and 7 and a dummy electrode 6' on its external surface, which are electrically separated from each other. A soda-lime glass is used for the base substrate 2 and the lid substrate 3. Since the base substrate 2 and the lid substrate 3 use the same material, a thermal expansion difference therebetween due to temperature changes can be reduced, thereby preventing peeling of the substrates from each other and the degradation of airtightness caused by the peeling. The base substrate 2 and the lid substrate 3 are bonded to each other by anodic bonding.

As illustrated in Figs. 2 and 3, the lid substrate 3 has a concave portion 3a on its inner surface to form a cavity 4 and thus accommodates the piezoelectric vibrating reed 5. The base substrate 2 and the lid substrate 3 are bonded to each other via a bonding material 13. The base substrate 2 and the lid substrate 3 have the rectangular shapes, and two through-electrodes 8 and 9 are exposed on the inner surface 23 along a substantially diagonal line. As viewed in Fig. 2, a lead-out electrode 14 is formed along an upper portion to a left side of the inner surface 23 of the base substrate 2 from an exposed surface of the through-electrode 9, and a lead-out electrode 14' is formed on an upper surface of the through-electrode 8. Conductive adhesive materials 15 and 15' are respectively formed on an upper surface of a left side of the lead-out electrode 14 and an upper surface of the lead-out electrode 14', and the piezoelectric vibrating reed 5 is mounted thereon. The conductive adhesive materials 15 and 15' hold the piezoelectric vibrating reed 5 in a cantilevered state. Bumps such as gold may be used for the conductive adhesive materials 15 and 15'. The through-electrodes 8 and 9 and wall surfaces of through-holes 11 and 12 are welded. The base substrate 2 and the lid substrate 3 are bonded to each other by anodic bonding. Accordingly, the cavity 4 is provided with airtightness against outside air.

Here, a piezoelectric material made of crystal, lithium tantalate, lithium niobate, or the like may be used as the piezoelectric vibrating reed 5. Excitation electrodes (not shown) are formed on an upper surface of the piezoelectric vibrating reed 5 and a lower surface thereof on the reverse side. One excitation electrode formed on the piezoelectric vibrating reed 5 is electrically connected to the outer electrode 7 via the conductive adhesive material 15, the lead-out electrode 14', and the through-electrode 9, and the other excitation electrode is electrically connected to the outer electrode 6 via the conductive adhesive material 15', the lead-out electrode 14, and the through-electrode 8. Kovar is used for the through-electrodes 8 and 9.

### First Embodiment

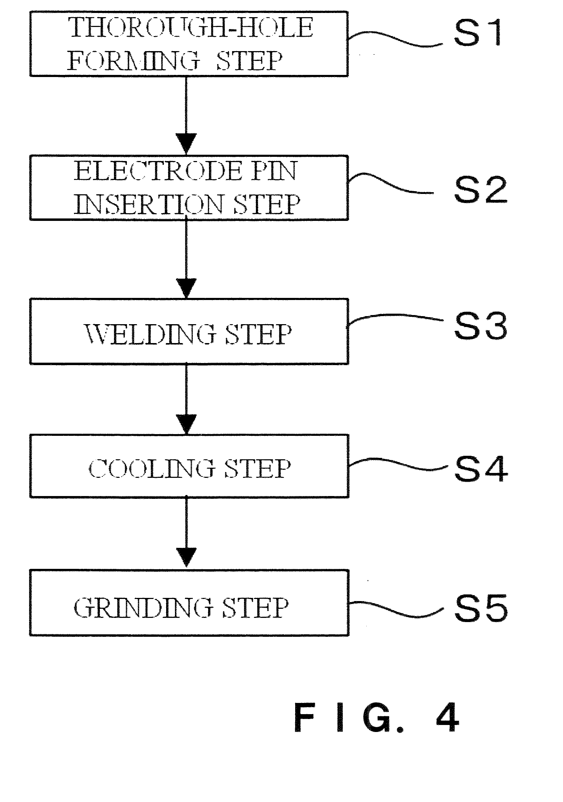

Fig. 4 is a flowchart illustrating the manufacturing method of the package 1 according to the first embodiment of the invention. The method of manufacturing a package according to the invention is a manufacturing method of the package 1 for bonding the lid substrate 3 on the base substrate 2 made of the glass material, forming the cavity 4 therein, and accommodating an electronic component in the cavity 4 as illustrated in Figs. 1 to 3.

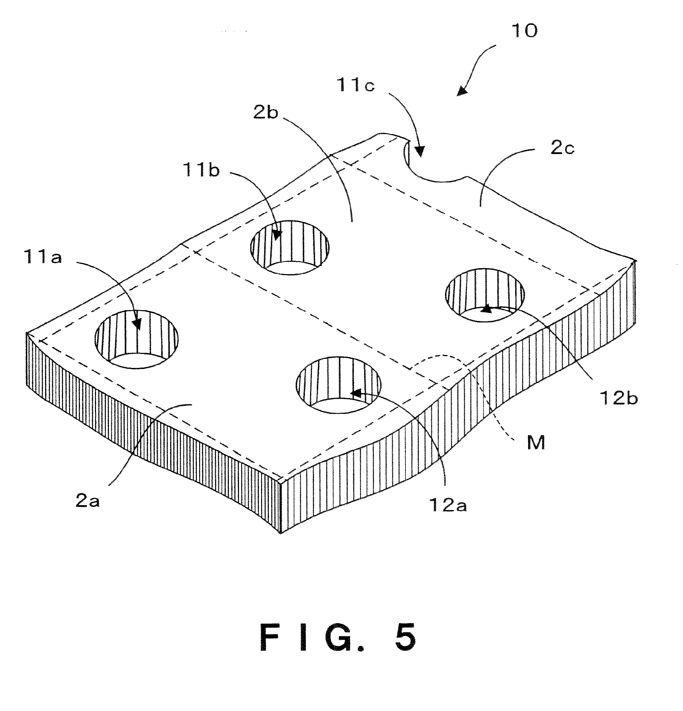

First, in a through-hole forming step S1, a glass substrate 10 is prepared, and a plurality of through-holes 11 and 12 is provided in the glass substrate 10. Fig. 5 is a perspective view schematically illustrating the glass substrate 10 in which a plurality of through-holes 11a, 12a, 11 b, 12b, and 11c is formed in the through-hole forming step S1. Dotted lines M are cutting lines, and when the glass substrate 10 is cut along the dotted lines M, a plurality of base substrates 2a, 2b, and 2c having the two through-holes 11 and 12 can be obtained. Here, a transparent glass such as soda-lime glass, borosilicate glass, or lead glass may be used for the glass substrate.

The through-holes 11 and 12 can be formed by grinding or etching. In addition, although described in detail according to a second embodiment, a convex portion is provided in at least one of a receiving die and a pressurizing die made of a carbon material, the glass substrate 10 is nipped between the receiving die and the pressurizing die and heated, a plurality of concave portions is provided on one surface of the glass substrate 10, and the other surface which is the reverse side to the one surface of the glass substrate 10 having the concave portions provided thereon is ground so as to penetrate a bottom surface of the concave portion.

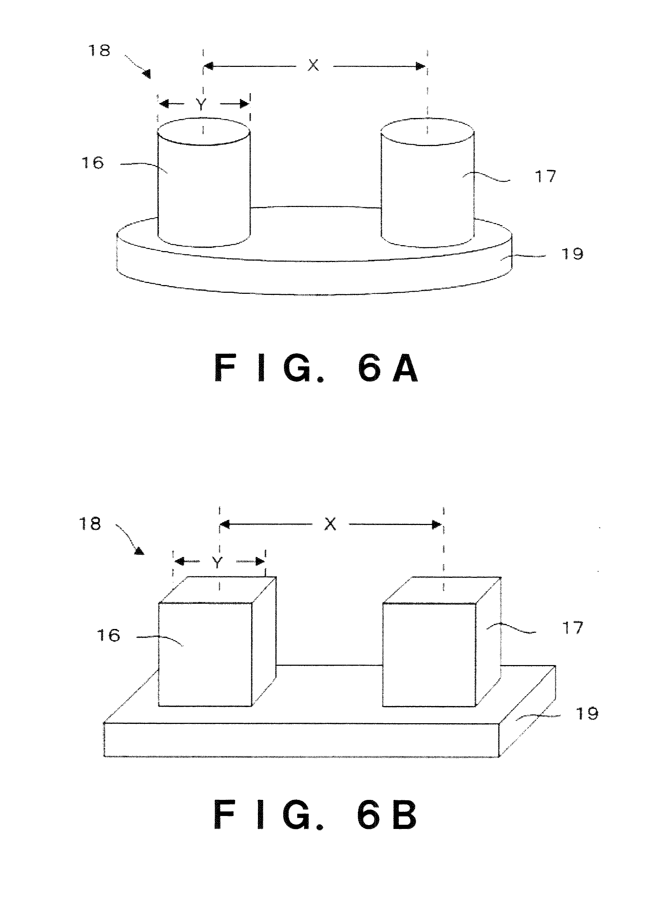

Figs. 6A and 6B are perspective views schematically illustrating electrode members 18. Fig. 6A illustrates an example of the electrode member 18 in which columnar pins 16 and 17 are erected on a disc-shaped base 19, and Fig. 6B illustrates an example of the electrode member 18 in which quadrilateral pins 16 and 17 are erected on a quadrilateral base 19. The bases 19 and the pins 16 and 17 are formed of metal or alloys. An interval X between the pins 16 and 17 is, for example, in the range of 0.5 mm to 1.5 mm, and a diameter Y of each of the pins 16 and 17 is in the range of 0.05 mm to 0.3 mm. The number of the pins 16 and 17 provided on the base 19 is not limited to 2, and a larger number of pins may also be erected. When, for example, Kovar or an Fe-Ni alloy is used for the electrode member 18, the electrode member 18 has a coefficient of thermal expansion approximate to that of the glass material, so that the through-electrodes 8 and 9 having excellent sealing ability can be formed.

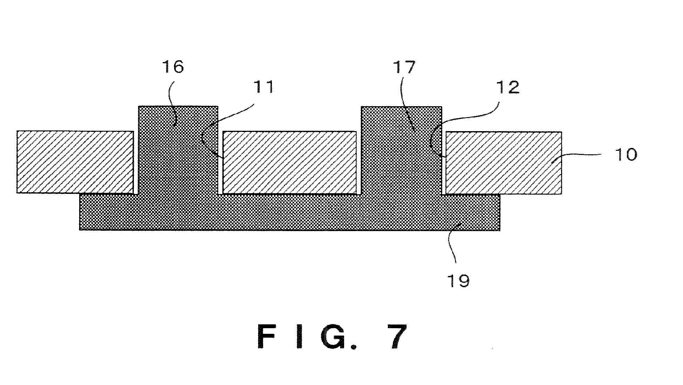

Next, in an electrode pin inserting step S2, the pins 16 and 17 of the electrode member 18 are inserted into the through-holes 11 and 12 of the glass substrate 10. Fig. 7 is a cross-sectional view schematically illustrating a state where the pins 16 and 17 are inserted into the through-holes 11 and 12. The two pins 16 and 17 erected on the base 19 may be inserted into the two through-holes 11 and 12, or a larger number of pins may be erected on a base so as to be simultaneously inserted into a number of through-holes.

Next, in a welding step S3, the glass substrate 10 is heated to a temperature higher than its softening point so that the pins 16 and 17 and the glass substrate 10 are welded to each other. During welding, the glass substrate 10 is interposed between the receiving die and the pressurizing die and pressed so as to accelerate fluidity of the glass material, thereby achieving welding in a short time. Since pins 16 and 17 are fixed to the base 19, although the glass substrate 10 is softened and flows, the pins 16 and 17 do not move or fall.

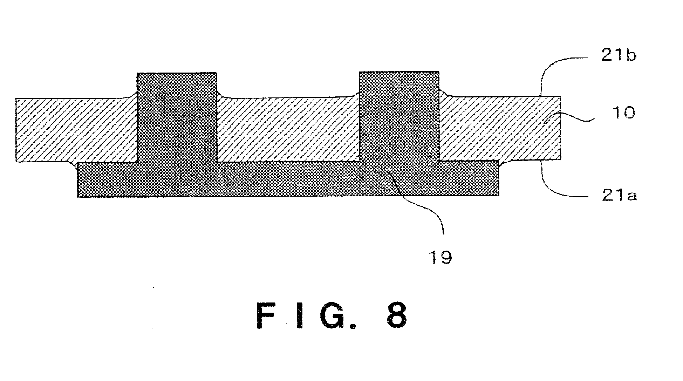

Next, in a cooling step S4, the glass substrate 10 is cooled. Fig. 8 is a cross-sectional view schematically illustrating the glass substrate 10 to which the electrode member 18 is welded. As such, since a side surface of the electrode pin is welded to the glass material, an interface therebetween has excellent airtightness, thereby enhancing reliability of an electronic component sealed therein. Moreover, in the cooling step S4, compared to a cooling rate applied during cooling to a temperature 50°C higher than the strain point of the glass substrate 10, a cooling rate applied during cooling from the temperature 50°C higher than the strain point thereof to a temperature 50°C lower than the strain point thereof may be set to be smaller. Accordingly, strain remaining in the glass substrate is reduced, and gaps or cracks generated between the pins 16 and 17 and the glass substrate 10 are prevented, thereby obtaining the package 1 with high reliability.

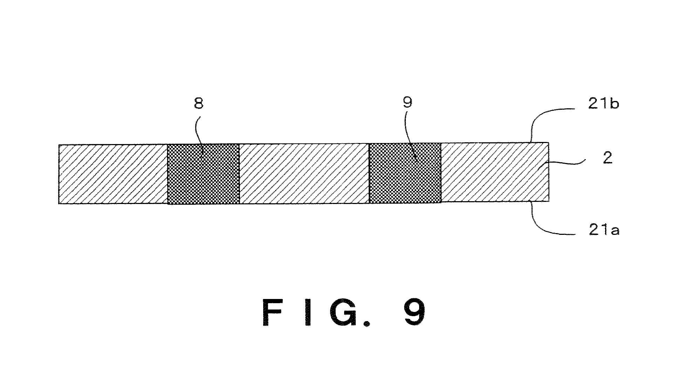

Next, in a grinding step S5, both surfaces of the glass substrate 10 are ground, the base 19 is removed from the one surface 21 a of the glass substrate 10, and protruding portions of the pins 16 and 17 are removed from the other surface 21 b thereof, thereby flattening both surfaces. Fig. 9 is a cross-sectional view schematically illustrating the glass substrate 10, that is, the base substrate 2 after the grinding step S5. The exposed surfaces of the through-electrodes 8 and 9 are flush with the surface of the base substrate 2.

As such, since the plurality of pins 16 and 17 is welded to the glass substrate 10 while being fixed to the base 19, although the diameters of the pins 16 and 17 are small within the range of 0.05 mm to 0.3 mm and the interval between the pins 16 and 17 is small within the range of 0.5 mm to 1.5 mm, welding can be performed with high position precision.

### Second Embodiment

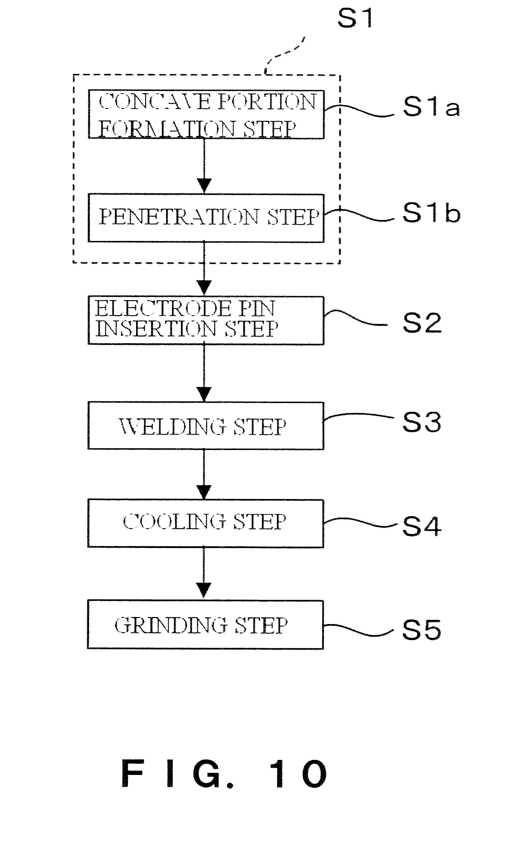

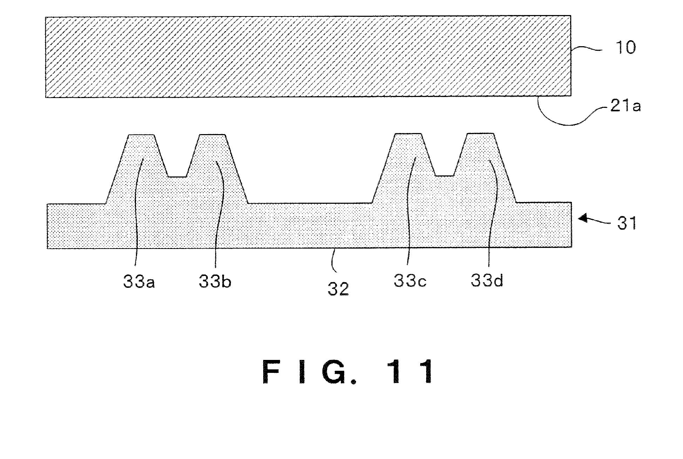

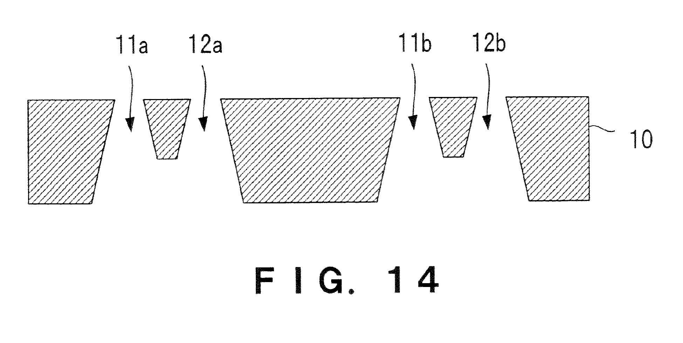

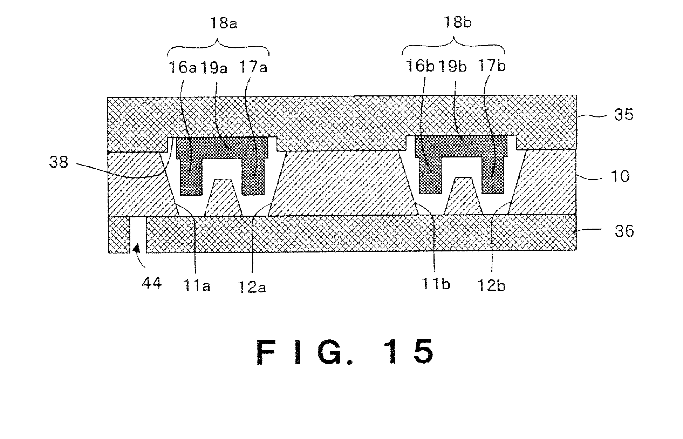

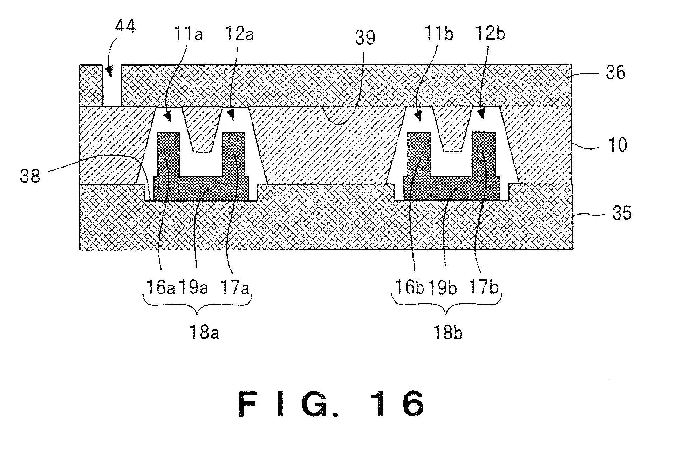

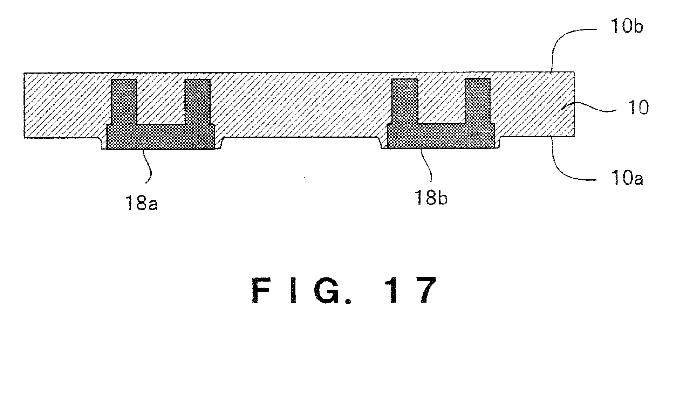

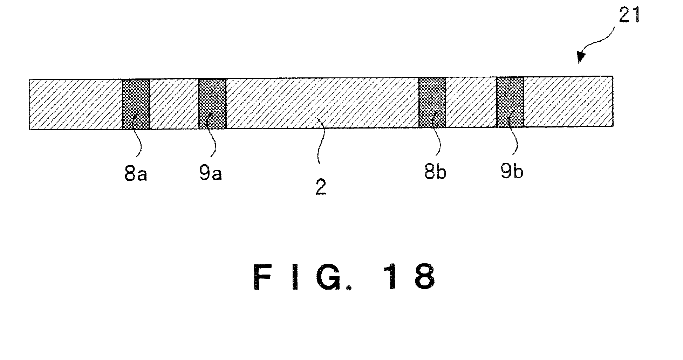

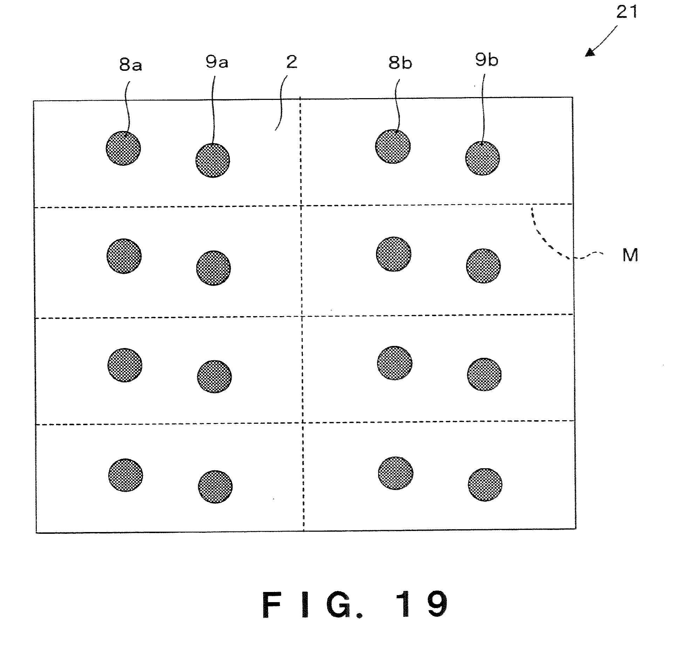

Fig. 10 is a flowchart illustrating the manufacturing method of the package 1 according to a second embodiment of the invention. Figs. 11 to 19 are explanatory views for explaining the manufacturing method of the package according to the second embodiment. Figs. 11 to 13 illustrate a concave portion forming step S1 a, Fig. 14 illustrates a penetrating step S1b, Figs. 15 and 16 illustrate an electrode pin inserting step S2, Fig. 17 is a cross-sectional view schematically illustrating the glass substrate 10 after the welding step S3 and the cooling step S4, and Figs. 18 and 19 are respectively a cross-sectional view and a top view schematically illustrating the base substrate 2 after the grinding step S5. According to the second embodiment, a method of manufacturing multiple products for simultaneously forming a number of the base substrates 2 from the glass substrate 10 is employed. Like elements which are the same or have the same functions as those above are denoted with like reference numerals.

As illustrated in Fig. 10, according to the second embodiment, the through-hole forming step S1 includes the concave portion forming step S1a of forming the concave portions on the glass substrate 10 and the penetrating step S1 b of erasing and penetrating the bottom surface of the corresponding concave portion. Figs. 11 to 13 are explanatory views of the concave portion forming step S1a of forming a plurality of the concave portions on the one surface 10a of the glass substrate 10. As illustrated in Fig. 11, the glass substrate 10 is placed above a concave portion formation die 31. A carbon material having excellent release properties from the glass material is used for the concave portion formation die 31. Furthermore, the carbon material may absorb bubbles releasing from the glass material and thus reduce porosity of pores remaining in the glass material. The concave portion formation die 31 includes a flat plate portion 32 and a plurality of convex portions 33a, 33b, 33c, and 33d provided on the upper surface thereof. Each of plurality of convex portions 33a, 33b, 33c, and 33d has a trapezoidal shape with inclined side surfaces for good release properties after molding. The convex portions 33a and 33b are used for forming the two through-electrodes 8a and 9a to be provided in the single base substrate 2, and the convex portions 33c and 33d are used for forming the two through-electrodes 8b and 9b to be provided in the base substrate 2 adjacent thereto. Since a distance between the through-holes 8 and 9 to be provided in the single base substrate 2 is, for example, in the range 0.5 mm to 1.5 mm and thus they are close to each other, portions between the convex portions 33a and 33b and between the convex portions 33c and 33d are higher than the surface of the flat plate portion 32.

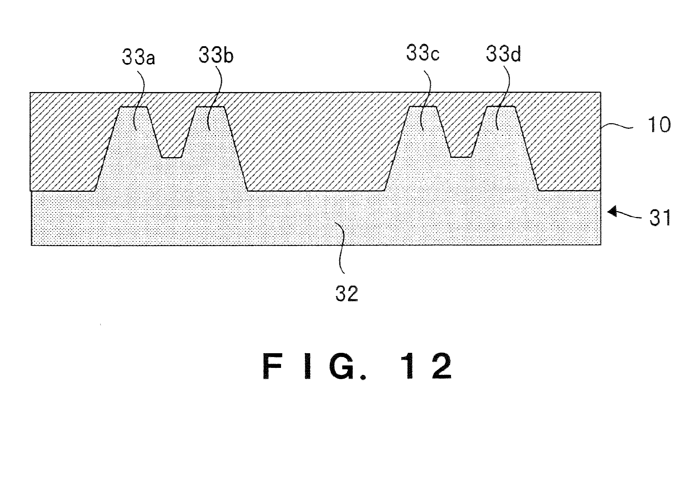

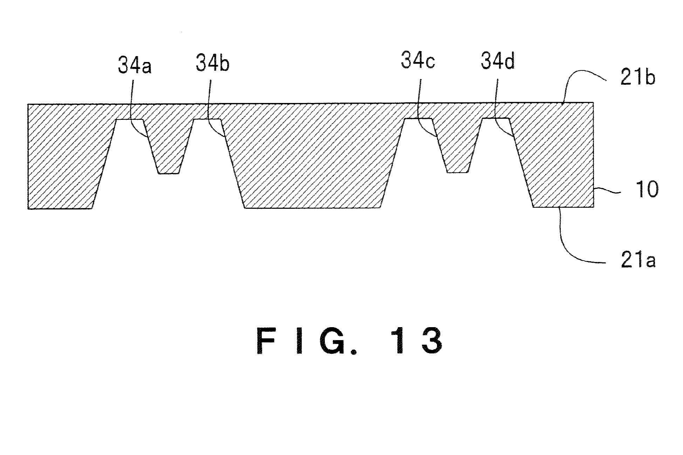

Fig. 12 is a cross-sectional view schematically illustrating a state where the concave portion formation die 31 and the glass substrate 10 are heated to a temperature equal to or higher than the softening point of the glass material. In order to accelerate molding of the glass material, when the glass substrate 10 is recessed from above, molding can be performed within a shorter time. Fig. 13 is a cross-sectional view schematically illustrating the glass substrate 10 after molding. The convex portions 33a, 33b, 33c, and 33d of the concave portion formation die 31 are transferred onto the one surface 21 a of the glass substrate 10 thereby forming transferred concave portions 34a, 34b, 34c, and 34d.

In the subsequent penetrating step S1 b, the other surface 10b which is on the reverse side to the one surface 10a of the glass substrate 10 is ground to penetrate the transferred concave portions 34a, 34b, 34c, and 34d through the other surface 21b. Fig. 14 is a cross-sectional view schematically illustrating the glass substrate 10 after the penetration step. As illustrated in Figs. 13 and 14, portions between the transferred concave portions 34a and 34b and between the transferred concave portions 34c and 34d become lower than the one surface 10a of the glass substrate 10.

Fig. 15 is a cross-sectional view schematically illustrating the electrode pin inserting step S2. Two pins 16a and 17a and two pins 16b and 17b respectively erected on the bases 19a and 19b of the two electrode members 18a and 18b are respectively inserted into the through-holes 11a and 12a and the through-holes 11 b and 12b of the glass substrate 10 so as to be interposed between the pressurizing die 36 and the receiving die 35. The electrode member 18 is as described above with reference to Figs. 6A and 6B. The electrode member 18 having the two pins 16 and 17 may be inserted into the through-holes 11 and 12 using a transfer machine. In addition, the electrode member 18 having a larger number of pins erected on the base 19 may be prepared so that a number of pins are simultaneously inserted into a number of through-holes. A carbon material having excellent release properties from glass is used for the pressurizing die 36 and the receiving die 35. The pressurizing die 36 is provided with a slit 44 so as to discharge residual bubbles to the outside. The receiving die 35 is provided with a base receiving portion 38 which is configured as a concave portion and receives the base 19 of the electrode member 18 so as not to significantly move the electrode member 18 in the horizontal direction in order to be fixed.

Fig. 16 illustrates a state where the pressurizing die 36 and the receiving die 35 are inversed upside down. In a state where the pressurizing die 36 is pressed against the receiving die 35, the glass substrate 10, the receiving die 35, and the pressurizing die 36 are heated to a temperature (for example, about 900°C) equal to or higher than the softening point (for example, 450°C) of the glass material. A pressure of, for example, 30 to 50 g/cm² is applied to the glass substrate 10. Then, the glass material is softened and flows so that side walls of the pins 16a, 17a, 16b, and 17b and inner wall surfaces of the through-holes 11a, 12a, 11 b, and 12b are welded to each other (the welding step S3). When glass is softened and flows, stress is exerted on the pins 16a, 17a, 16b, and 17b. However, the pins 16a and 17a or the pins 16b and 17b are fixed to the base 19a or 19b and thus are not moved. Accordingly, relative position precision of the pins 16a and 17a and the pins 16b and 17b can be ensured. The bases 19 are fixed to the base receiving portions 38 of the receiving die 35 and thus are not significantly moved in the horizontal direction. In addition, bubbles remaining inside are discharged to the outside through the slit 44.

Next, the receiving die 35, the pressurizing die 36, and the glass substrate 10 are cooled (cooling step S4), and the glass substrate 10 is taken out. Fig. 17 is a cross-sectional view schematically illustrating the glass substrate 10 taken out after the cooling step S4. In the cooling step S4, compared to the cooling rate applied during cooling to the temperature 50°C higher than the strain point of the glass substrate 10, the cooling rate applied during cooling from the temperature 50°C higher than the strain point thereof to the temperature 50°C lower than the strain point thereof is set to be smaller. Accordingly, strain remaining in the glass substrate can be reduced. As a result, gaps and cracks in the interface between the pins 16a, 17a, 16b, and 17b and the glass substrate 10 due to the thermal expansion difference are prevented, and thus airtightness between the through-electrodes 8a, 9a, 8b, and 9b and the base substrate 2 can be held, thereby enhancing reliability of the electronic component accommodated therein.

Fig. 18 is a cross-sectional view schematically illustrating the base substrate 2 after the grinding step S5. Grinding is performed on both surfaces of the glass substrate 10, the bases 19a and 19b are erased from the one surface 10a, and the pins 16a, 17a, 16b, and 17b are exposed from the other surface 10b, thereby forming the number of the base substrates 2 (hereinafter, referred to as glass wafers 21) in which the through-electrodes 8a, 9a, 8b, and 9b which are electrically separated from each other are implanted. A thickness of the glass wafer 21 is equal to or smaller than 0.5 mm, and for example, about 0.2 mm.

Fig. 19 is a top view schematically illustrating the glass wafer 21 in which a number of the base substrates 2 are simultaneously formed. Each of the base substrates 2 includes the two through-electrodes 8 and 9. Dotted lines M are lines for separating and cutting the glass wafer 21. The lines for separating and cutting may be engraved on the surface of the glass substrate 10 in the welding step S3 during molding by forming protrusions on the receiving die 35 or the pressurizing die 36. A number of the pins are erected on the base 19 and inserted into a number of the through-holes to be welded simultaneously, thereby simultaneously forming a number of the through-electrodes.

As such, the pins 16 and 17 fixed to the base 19 are inserted through the through-holes 11 and 12 and the pins 16 and 17 and the glass material are welded to each other, so that the through-electrodes 8 and 9 having high airtightness can be simply formed with high position precision. Accordingly, a number of packages of electronic components which have small electrode diameters and small intervals between the electrodes and require high reliability can be formed simultaneously.

### Third Embodiment

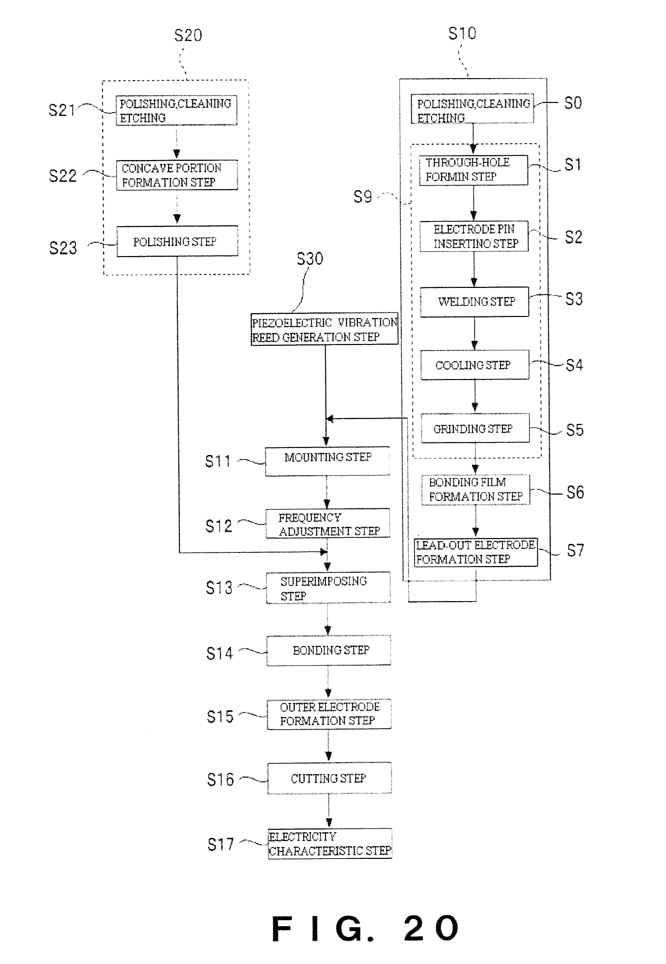

Fig. 20 is a flowchart illustrating the method of manufacturing a piezoelectric vibrator according to a third embodiment of the invention. A completed drawing of the piezoelectric vibrator is as illustrated in Figs. 1 to 3. The third embodiment includes a base substrate forming step S10, a lid substrate forming step S20, and a piezoelectric vibrating reed generating step S30. Hereinafter, the workflow will be described.

First, in a polishing, washing, and etching step S0 a glass substrate is polished and washed, and then the glass substrate is subjected to etching to remove a work-affected layer on its outermost surface. Next, in a through-electrode forming step S9, as in the first or second embodiment, a glass wafer 21 having the through-electrodes 8 and 9 implanted in the glass substrate 10 is formed. The soda-lime glass may be used as the glass material.

Specifically, in the through-hole forming step S1, a plurality of the through-holes 11 and 12 is provided in the glass substrate 10. First, in the concave portion formation step, the glass substrate 10 is placed on the concave portion formation die 31, and is heated to the softening point of glass or higher to form a plurality of the transferred concave portions 34 on the one surface 10a of the glass substrate 10. A carbon material may be used as the concave portion formation die 31. The carbon material has an excellent release property from the glass material and absorbs gases discharged from the glass material, thereby reducing porosity of pores remaining in the glass material. Next, in the penetration step, the other surface 10b on the reverse side to the one surface 10a of the glass substrate 10 is ground, and the bottom surface of the transferred concave portion 34 is opened to form the through-holes 11 and 12.

Next, in the electrode pin inserting step S2, the electrode member 18 having the plurality of the pins 16 and 17 erected on the base 19 is prepared, and the plurality of the pins 16 and 17 of the electrode member 18 is inserted into the through-holes 11 and 12 of the glass substrate 10. Kovar is used for the electrode member 18. The glass substrate 10 in which the electrode member 18 is mounted is nipped between the receiving die 35 and the pressurizing die 36. The receiving die 35 is provided with the base receiving portion 38, and the base 19 of the electrode member 18 is mounted on the base receiving portion 38. The pressurizing die 36 may have a flat plate surface as an abutting surface abutting the glass substrate 10 or may be provided with protrusions for scribe lines for easily separating and cutting the glass substrate 10.

Next, in the welding step S3, the receiving die 35 and the pressurizing die 36 with the glass substrate 10 nipped therebetween are introduced into an electric furnace, and heated to the softening point of the glass material or higher, for example, to 900°C and simultaneously the pressurizing die 36 is pressed. Accordingly, the glass material is made to flow and the side surfaces of the pins 16 and 17 and the side walls of the through-holes 11 and 12 are welded to each other. The glass material becomes a viscous flow and moves such that a stress is applied to the pins 16 and 17. However, since the pins 16 and 17 are fixed to the base 19 and mounted on the base receiving portion 38 of the receiving die 35, the pins 16 and 17 are not moved.

Next, in the cooling step S4, the receiving die 35, the glass substrate 10, and the pressurizing die 36 are cooled. During the cooling of the glass substrate 10, for example, compared to the cooling rate applied during cooling to the temperature 50°C higher than the strain point of the glass substrate 10, the cooling rate applied during cooling from the temperature 50°C higher than the strain point thereof to the temperature 50°C lower than the strain point thereof is set to be smaller. Accordingly, strain remaining in the glass substrate 10 can be reduced. As a result, it is possible to prevent degradation in reliability of electronic components caused by degradation of airtightness between the through-electrodes and the base substrate due to gaps between pins and glass that are generated due to the thermal expansion difference between the pins 16 and 17 and the glass substrate 10, or cracks that are generated from the vicinity of the gaps.

Next, in the grinding step S5, both surfaces of the glass substrate 10 are ground along with the electrode member 18 and thus the base 19 of the electrode member 18 is removed, and the pins 16 and 17 are electrically separated from each other, thereby forming the through-electrodes 8 and 9. For example, both surfaces can be simultaneously ground using a double-sided polishing machine. Accordingly, the glass wafer 21 in which the exposed surfaces of the through-electrodes 8 and 9 and the surface of the base substrate 2 are flush with each other and thus have a high degree of planarity can be formed.

Next, in a bonding film forming step S6, a bonding film for anodic bonding is deposited on an area which becomes the vicinity of the base substrate 2. An aluminum film is deposited as the bonding film. Next, in a lead-out electrode forming step S7, the lead-out electrode 14 is formed from the upper surface of the one through-electrode 9 along an outer peripheral portion of the base substrate 2. The lead-out electrode 14 is formed by depositing an Au/Cr film using sputtering and performing patterning using photolithography or etching. In addition, the lead-out electrode 14 may also be formed using printing instead of the sputtering. The base substrate forming step S10 has been described above.

Next, the lid substrate forming step S20 will be described. In order to reduce the thermal expansion difference when the lid substrate 3 is bonded to the base substrate 2, the same material as that used for the base substrate 2 may be used for the lid substrate 3. When soda-lime glass is used for the base substrate 2, the same material is used for the lid substrate 3. First, in the polishing, washing, and etching step S21, the glass substrate is polished, and the glass substrate is subjected to etching to remove the work-affected layer on its outermost surface and is then washed.

Next, in the concave portion forming step S22, the concave portion 3a is formed by die-molding. The concave portion 3a is created by nipping the glass substrate between a receiving die having a convex portion and a pressurizing die having a concave portion, is heated to the softening point of the glass material or higher, and is pressed to be molded. It is preferable that the molding die be formed of the carbon material because the carbon material has an excellent release property from glass and an excellent property of absorbing bubbles. Next, in the polishing step S23, the bonding surface bonded to the base substrate 2 is polished to be a flat surface. Accordingly, sealing ability can be enhanced when the bonding surface is bonded to the base substrate 2.

Next, in the piezoelectric vibrating reed generating step S30, the piezoelectric vibrating reed 5 made of a crystal plate is prepared. The excitation electrodes which are electrically separated from each other are provided on both surfaces of the piezoelectric vibrating reed 5 and are electrically connected to a terminal electrode formed on a surface of one end of the piezoelectric vibrating reed 5. Next, in a mounting step S11, the conductive adhesive material 15, for example, the metal bump is formed on the end portions of the through-electrode 8 of the base substrate 2 and the lead-out electrode 14 or on the terminal electrode of the piezoelectric vibrating reed 5. The piezoelectric vibrating reed 5 is cantilevered by the conductive adhesive material 15. Accordingly, the excitation electrodes formed on both surfaces of the piezoelectric vibrating reed 5 are electrically separated from each other and conduct through the two through-electrodes 8 and 9.

Next, in a frequency adjustment step S12, a vibration frequency of the piezoelectric vibrating reed 5 is adjusted to a predetermined frequency. Next, in a superimposing step S13, the lid substrate 3 is installed and superimposed on the base substrate 2 with the bonding material 13 interposed therebetween. Next, in a bonding step S14, the base substrate 2 and the lid substrate 3 superimposed thereon are heated, and a high voltage is applied to the base substrate 2 and the lid substrate 3 for anodic bonding. Next, in an outer electrode forming step S15, the outer electrodes 6 and 7 which are electrically connected to the through-electrodes 8 and 9, respectively, are formed on the outer surface of the base substrate 2. Next, in a cutting step S16, the glass wafer 21 is separated and cut along the cutting lines, thereby obtaining individual piezoelectric vibrators 20.

As such, the pins 16 and 17 fixed to the base 19 are inserted through the through-holes 11 and 12 and the pins 16 and 17 and the glass material are welded to each other, so that position precision and airtightness of the through-electrodes 8 and 9 can be enhanced, thereby providing the piezoelectric vibrator 20 having small electrode diameters and small electrode intervals of the through-electrodes 8 and 9.

Fig. 20 also shows an optional electricity characteristic step S17.

### Oscillator

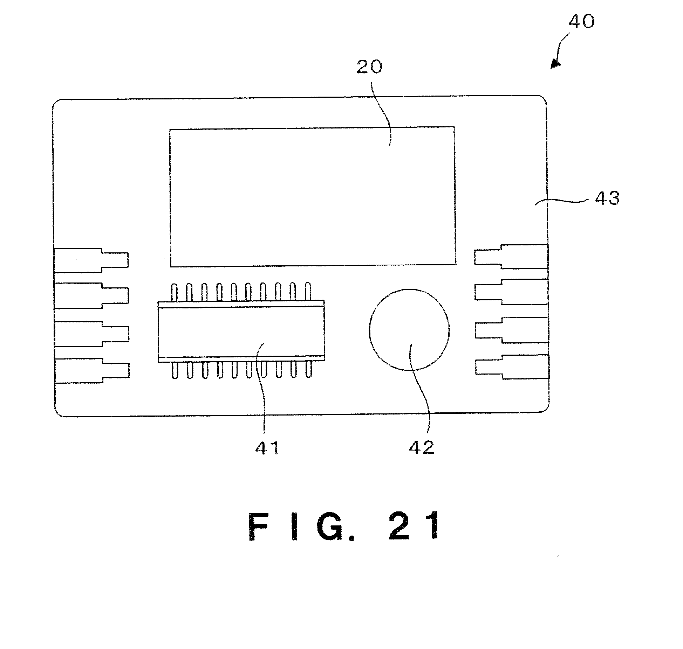

Fig. 21 is a top view schematically illustrating an oscillator 40 which is formed by using the package 1 or the piezoelectric vibrator 20 manufactured by the manufacturing method according to the invention. As illustrated in Fig. 21, the oscillator 40 includes a substrate 43, the piezoelectric vibrator 20 installed on the substrate, an integrated circuit 41, and an electronic component 42. The piezoelectric vibrator 20 generates a signal with a predetermined frequency on the basis of a drive signal that may be transmitted to the outer electrodes 6 and 7, and the integrated circuit 41 and the electronic component 42 process the signal with the predetermined frequency supplied from the piezoelectric vibrator 20 and generate a reference signal such as a clock signal. The piezoelectric vibrator 20 according to the invention can be formed with high reliability and to have a small size, thereby achieving a compact size for the oscillator 40.

The foregoing description has been given by way of example only and it will be appreciated by a person skilled in the art that modifications can be made without departing from the scope of the present invention.

## Claims

1. A method of manufacturing a package for bonding a lid substrate (3) onto a base substrate (2) made of a glass material and accommodating an electronic component (5) in a cavity configured therein, comprising:
a through-hole forming step (S1) of providing a plurality of through-holes (11, 12) in a glass substrate (10);
an electrode pin inserting step (S2) of preparing an electrode member (18) having a plurality of pins (16, 17) erected on a base (19), and inserting the plurality of pins into the plurality of through-holes respectively;
a welding step (S3) of heating the glass substrate to a temperature higher than the softening point of the glass substrate and welding the glass substrate and the electrode member to each other; and
a grinding step (S5) of grinding both surfaces (21 a, 21 b) of the glass substrate along with the electrode member, exposing the plurality of pins from both surfaces of the glass substrate, and forming a base substrate having a plurality of through-electrodes in which through-electrodes are electrically separated from each other.

2. The manufacturing method according to claim 1, wherein in the welding step, the glass substrate into which the plurality of pins is inserted is nipped between a receiving die (36) and a pressurizing die (35) and pressurized.

3. The manufacturing method according to claim 1 or 2, wherein the through-hole forming step includes:
a concave portion forming step (S1 a) of providing a plurality of convex portions (33a-d) in any one of the receiving die and the pressurizing die made of a carbon material, nipping the glass substrate between the receiving die and the pressurizing die and heating, and forming a plurality of concave portions (34a-d) on one surface of the glass substrate; and
a penetrating step (S1 b) of grinding the other surface which is on the reverse side to the one surface of the glass substrate, and penetrating the plurality of concave portions from the one surface to the other surface.

4. The manufacturing method according to any one of claims 1 to 3, further comprising a cooling step (S4) of cooling the glass substrate and the electrode member after the welding step,
wherein in the cooling step, compared to a cooling rate applied during cooling to a temperature 50°C higher than a strain point of the glass substrate, a cooling rate applied during cooling from the temperature 50°C higher than the strain point thereof to a temperature 50°C lower than the strain point thereof is set to be smaller.

5. The manufacturing method according to any one of claims 1 to 4, wherein an axis-to-axis distance (X) between center axes of the plurality of pins is in the range of 0.5 mm to 1.5 mm.

6. A method of manufacturing a piezoelectric vibrator comprising:
a mounting step of mounting a piezoelectric vibrator on the base substrate manufactured as the package as per the method of manufacturing a package according to any one of claims 1 to 5; and
a bonding step of bonding the lid substrate to the base substrate by anodic bonding.
